# EUROPEAN PATENT APPLICATION

(11) **EP 4 842 151 A1**
(43) Date of publication of application: **18.11.2026**
(21) Application number: 25758695.8
(22) Date of filing: 14.02.2025
(51) Int. Cl.: H05K 5/04, H04M 1/02, G04G 17/08

(54) **ELECTRONIC DEVICE INCLUDING METAL HOUSING**

(30) Priority: 19.02.2024 KR 20240023548; 17.05.2024 KR 20240064500
(71) Applicant: Samsung Electronics Co., Ltd., Suwon-si, Gyeonggi-do 16677 (KR)
(72) Inventor: KIM, Younggyun, Suwon-si Gyeonggi-do 16677 (KR); HWANG, Yoonyoung, Suwon-si Gyeonggi-do 16677 (KR); AHN, Byoungju, Suwon-si Gyeonggi-do 16677 (KR)
(74) Representative: Gulde & Partner
(86) International application number: PCT/KR2025/099372
(87) International publication number: WO 2025/178446

(57) **Abstract**

This electronic device comprises: a side frame forming a side surface of the electronic device; and a metal housing connected to an inner side of the side frame and including a bracket positioned inside the electronic device. The side frame includes: a first metal member exposed to the outside of the electronic device and including a first metal material; a second metal member connected to the first metal member along the inner circumference of the first metal member and including a second metal material; and a bonding region formed around a bonding interface between the first metal member and the second metal member and in which the first metal material and the second metal material are mixed. The bonding region includes: a first diffusion layer formed from the bonding interface to the first metal member; and a second diffusion layer formed from the bonding interface to the second metal member.

## Description

### TECHNICAL FIELD

The disclosure relates to an electronic device including a housing that is formed of a metal material.

### BACKGROUND ART

Wireless communication technology enables the transmission and reception of various forms of information. As wireless communication technology advances, electronic devices capable of wireless communication, such as smartphones, may provide services utilizing communication functions such as global positioning system (GPS), wireless-fidelity (Wi-Fi), long-term evolution (LTE), and near field communication (NFC). To perform such wireless communication, an electronic device may include an antenna structure. The above description is information the inventor(s) acquired during the course of conceiving the present disclosure, or already possessed at the time, and is not necessarily art publicly known before the present application is filed.

### SUMMARY OF THE INVENTION

### EFFECTS OF THE INVENTION

An electronic device, according to an embodiment, includes a metal housing including a side frame forming a side surface of the electronic device and a bracket connected to an interior of the side frame and disposed in the electronic device. In an embodiment, the side frame includes a first metal member exposed on an exterior of the electronic device and including a first metal material, a second metal member connected to the first metal member along an inner perimeter of the first metal member and including a second metal material, and a bonding region formed around a bonding interface between the first metal member and the second metal member and including a mixture of the first metal material and the second metal material. In an embodiment, the bonding region includes a first diffusion layer extending from the bonding interface to the first metal member and a second diffusion layer extending from the bonding interface to the second metal member.

In an embodiment, a melting point of the first metal material may be higher than a melting point of the second metal material. In an embodiment, a difference between the melting point of the first metal material and the melting point of the second metal material may be 300°C or less. In an embodiment, based on the bonding interface, a thickness of the first diffusion layer may be less than or equal to a thickness of the second diffusion layer. In an embodiment, the first metal material may have a higher hardness than the second metal material.

In an embodiment, the first metal member may include a first contact portion extending toward an interior of the electronic device and being in contact with the contact member. In an embodiment, the first metal material and a third metal material forming the contact member may have a potential difference of 0.2 or less. In an embodiment, the second metal member may include a second contact portion that is in contact with the contact member.

An electronic device, according to an embodiment, includes a housing structure including a first metal member exposed to an outside to form a side surface of the electronic device and including a first metal material, a second metal member bonded to the first metal member along an inner perimeter of the first metal member and including a second metal material, and an insulating member including an insulating material, and a printed circuit board (PCB) on which a wireless communication circuit is disposed. In an embodiment, a bonding region is formed around a bonding interface between the first metal member and the second metal member. In an embodiment, the bonding region includes a first diffusion layer and a second diffusion layer respectively formed in the first metal member and the second metal member with the bonding interface therebetween, the first diffusion layer and the second diffusion layer including a mixture of the first metal material and the second metal material. In an embodiment, the insulating member is connected to the first metal member and the second metal member to cover the bonding region.

In an embodiment, a melting point of the first metal material may be higher than a melting point of the second metal material. In an embodiment, based on the bonding interface, a first thickness from the bonding interface to a boundary of the first diffusion layer may be less than or equal to a second thickness from the bonding interface to a boundary of the second diffusion layer.

In an embodiment, the PCB may include one or more contact members electrically connected to the wireless communication circuit. In an embodiment, the one or more contact members may be in contact with the first metal member or the second metal member.

A wearable electronic device, according to an embodiment, includes a housing structure including a front surface, a rear surface, and a side surface surrounding a space between the front surface and the rear surface and including a side frame forming at least a portion of the side surface and a strap detachably connected to the housing structure and configured to be worn on a body of a user. In an embodiment, the side frame includes a first metal member including a first metal material, forming at least a portion of the side surface, and exposed to an outside, a second metal member connected to the first metal member along an inner perimeter of the first metal member and including a second metal material, and a bonding region formed around a bonding interface between the first metal member and the second metal member and including a mixture of the first metal material and the second metal material. In an embodiment, the bonding region includes a first diffusion layer extending from the bonding interface to the first metal member and a second diffusion layer extending from the bonding interface to the second metal member. In an embodiment, based on the bonding interface, a thickness of the first diffusion layer is less than or equal to a thickness of the second diffusion layer.

The effects of the electronic device including a metal housing according to embodiments are not limited to the above-mentioned effects, and other unmentioned effects can be clearly understood from the following description by one of ordinary skill in the art.

### BRIEF DESCRIPTION OF THE DRAWINGS

The foregoing and other aspects, features, and advantages of embodiments in the disclosure will become apparent from the following detailed description referring to the accompanying drawings.
FIG. 1 is a block diagram illustrating an electronic device in a network environment according to an embodiment.
FIG. 2a is a front perspective view of an electronic device according to an embodiment.
FIG. 2b is a rear perspective view of an electronic device according to an embodiment.
FIG. 3a is an exploded perspective view of an electronic device according to an embodiment.
FIG. 3b is a diagram illustrating a metal housing of an electronic device according to an embodiment.
FIG. 4a is a cross-sectional view of an example metal housing along line A-A of FIG. 3b for illustrating the structure of a metal housing according to an embodiment.
FIG. 4b is a diagram of an example shape of region B of FIG. 3b for illustrating a side frame according to an embodiment.
FIG. 4c is an enlarged view of a bonding portion of a first metal member and a second metal member for illustrating a bonding region according to an embodiment.
FIG. 5a is a partial cross-sectional perspective view of a coupling structure of a first metal member and a second metal member, according to an embodiment.
FIG. 5b is a diagram of an example shape of region C of FIG. 3b for illustrating a coupling structure of a side frame and an insulating member, according to an embodiment.
FIG. 5c is a diagram of an example shape of region E of FIG. 3b for illustrating a coupling structure of a side frame and a bracket, according to an embodiment.
FIG. 6a is a diagram of an example shape of region D of FIG. 3b for illustrating a connection structure between a first metal member and a contact member, according to an embodiment.
FIG. 6b is a diagram of an example shape of region B of FIG. 3b for illustrating a connection structure between a second metal member and a contact member, according to an embodiment.
FIG. 7 is a cross-sectional view of an example metal housing along line A-A of FIG. 3b for illustrating a metal housing according to an embodiment.
FIG. 8a is a front perspective view of a wearable electronic device according to an embodiment.
FIG. 8b is a rear perspective view of a wearable electronic device according to an embodiment.
FIG. 8c is an exploded perspective view of a wearable electronic device according to an embodiment.
FIG. 9 is an example exploded perspective view of a housing structure of a wearable electronic device according to an embodiment.

### BEST MODE(S) FOR CARRYING OUT THE INVENTION

Hereinafter, embodiments will be described in detail with reference to the accompanying drawings. When describing the embodiments with reference to the accompanying drawings, like reference numerals refer to like elements, and a repeated description related thereto will be omitted.

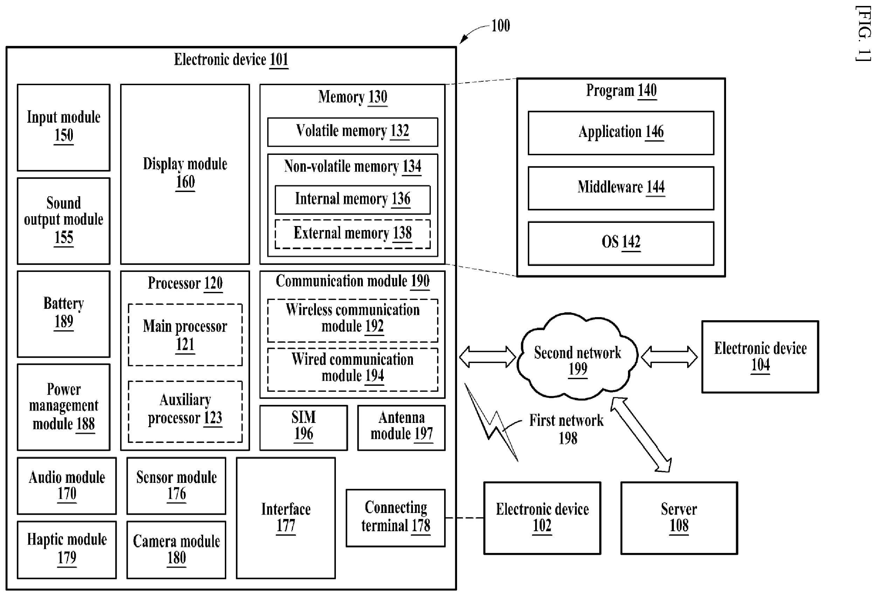

FIG. 1 is a block diagram of an electronic device 101 in a network environment 100 according to various embodiments.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one of the components (e.g., the connecting terminal 178) may be omitted from the electronic device 101, or one or more other components may be added to the electronic device 101. In an embodiment, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an ISP or a CP) may be implemented as part of another component (e.g., the camera module 180 or the communication module 190) functionally related to the auxiliary processor 123. According to an embodiment, the auxiliary processor 123 (e.g., the NPU) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a conventional neural network (CNN), a recurrent neural network (RNN), a restricted Boltzmann machine (RBM), a deep belief network (DBN), a bidirectional recurrent deep neural network (BRDNN), a deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or an external electronic device (e.g., the electronic device 102) (e.g., a speaker or headphones) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

The connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, ISPs, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs that are operable independently from the processor 120 (e.g., the AP) and support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 Eb or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may then be transmitted or received between the communication module 190 and the external electronic device via the selected at least one antenna. According to some embodiments, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a PCB, an RFIC disposed on a first surface (e.g., the bottom surface) of the PCB, or adjacent to the first surface and capable of supporting a designated high-frequency band (e.g., the mmWave band), and a plurality of antennas (e.g., array antennas) disposed on a second surface (e.g., the top or a side surface) of the PCB, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, cloud computing, distributed computing, mobile edge computing (MEC), or client-server computing technology may be used, for example. The electronic device 101 may provide ultra low-latency services using, e.g., distributed computing or MEC. In another embodiment, the external electronic device 104 may include an Internet-of Things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

It should be appreciated that the embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively," as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry." A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., the internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include code generated by a compiler or code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

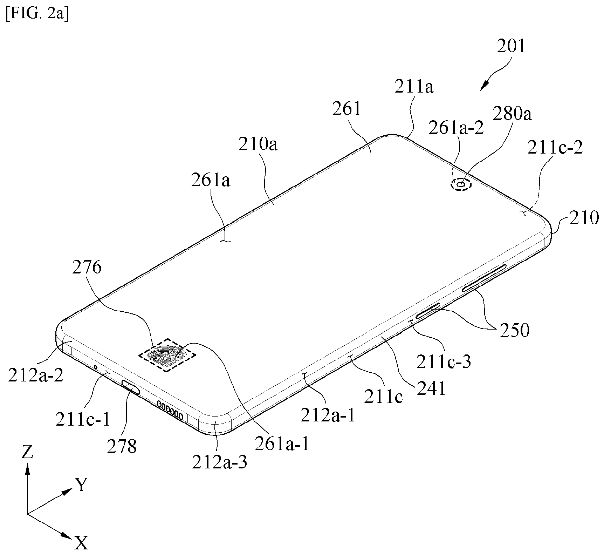

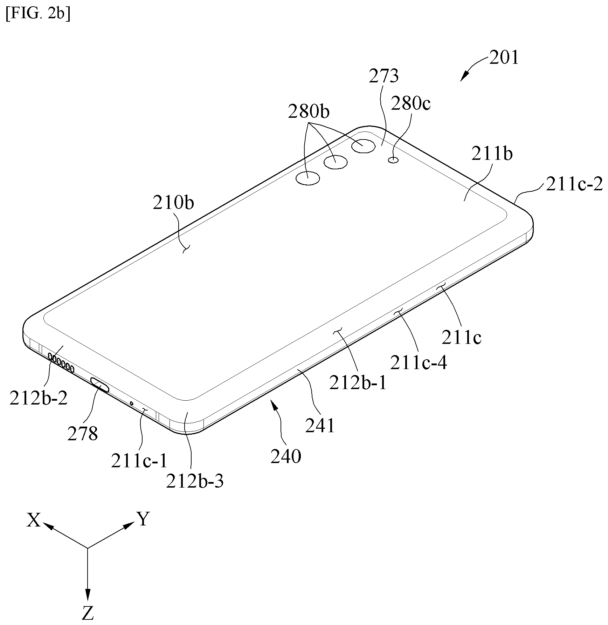

FIG. 2a is a front perspective view of an electronic device according to an embodiment. FIG. 2b is a rear perspective view of an electronic device according to an embodiment.

Referring to FIGS. 2a and 2b, an electronic device 201 (e.g., the electronic device 101 of FIG. 1) may include a front surface 210a (or a first surface), a rear surface 210b (or a second surface), and a side surface 211c surrounding the space between the front surface 210a and the rear surface 210b.

The electronic device 201, according to an embodiment, may include a housing structure 210 that forms an exterior and accommodates components therein. The housing structure 210 may form the front surface 210a (e.g., the surface facing the +Z direction), the rear surface 210b (e.g., the surface facing the -Z direction), and the side surface 211c surrounding the inner space between the front surface 210a and the rear surface 210b. In an embodiment, the housing structure 210 may form the side surface 211c through a first side surface 211c-1 (e.g., the surface facing the -Y direction), a second side surface 211c-2 (e.g., the surface facing the +Y direction), a third side surface 211c-3 (e.g., the surface facing the +X direction), and a fourth side surface 211c-4 (e.g., the surface facing the -X direction) connecting the front surface 210a to the rear surface 210b.

In an embodiment, the housing structure 210 may include a front plate 211a that forms the front surface 210a of the electronic device 201. In an embodiment, at least a portion of the front plate 211a may be formed to be substantially transparent. For example, the front plate 211a may include a polymer plate or a glass plate including at least one coating layer. In an embodiment, the housing structure 210 may include a rear plate 211b that forms the rear surface 210b of the electronic device 201. In an embodiment, the rear plate 211b may be formed to be substantially opaque. For example, the rear plate 211b may be formed by coated or colored glass, ceramic, polymer, metal (e.g., aluminum, stainless steel, or magnesium), or a combination thereof. In an embodiment, the housing structure 210 may include a metal housing 240. In an embodiment, the metal housing 240 may form the side surface 211c of the electronic device 201 through at least a portion of the metal housing 240. For example, the metal housing 420 may include a side frame 241 forming the side surface 211c of the electronic device 201. The surface of the side frame 241 may be exposed to the outside. In an embodiment, the metal housing 240 may be coupled to the front plate 211a and the rear plate 211b. The metal housing 240 may include metal and/or polymer. In an embodiment, the side frame 241 may be formed integrally and seamlessly with the rear plate 211b. In an embodiment, at least a portion of the metal housing 240 may be formed of substantially the same material (e.g., aluminum) as the rear plate 211b; however, embodiments are not limited thereto. For example, the metal housing 240 may include various types of metal materials.

In an embodiment, the front plate 211a may include a plurality of first periphery regions 212a-1 facing one direction (e.g., the +/-X direction), extending from at least a partial region of the front surface 210a to the rear plate 211b, and having a rounded surface, a plurality of second periphery regions 212a-2 facing another direction (e.g., the +/-Y direction), extending from at least a partial region of the front surface 210a to the rear plate 211b, and having a rounded surface, and a plurality of third periphery regions 212a-3 extending from at least a partial region of the front surface 210a to the rear plate 211b with a rounded surface, and positioned between the plurality of first periphery regions 212a-1 and the plurality of second periphery regions 212a-2.

In an embodiment, the rear plate 211b may include a plurality of fourth periphery regions 212b-1 facing one direction (e.g., the +/-X direction), extending from at least a partial region of the rear surface 210b to the front plate 211a, and having a rounded surface, a plurality of fifth periphery regions 212b-2 facing another direction (e.g., the +/-Y direction), extending from at least a partial region of the rear surface 210b to the front plate 211a, and having a rounded surface, and a plurality of sixth periphery regions 212b-3 extending from at least a partial region of the rear surface 210b to the front plate 211a with a rounded surface, and positioned between the plurality of fourth periphery regions 212b-1 and the plurality of fifth periphery regions 212b-2.

In an embodiment, the metal housing 240 may surround at least a portion of the space formed between the front surface 210a and the rear surface 210b of the electronic device 201. In an embodiment, a display 261 may be positioned on one surface (e.g., +Z direction) of the metal housing 240. The rear plate 211b may be disposed on the other surface (e.g., -Z direction) of the metal housing 240.

In an embodiment, the electronic device 201 may include the display 261 (e.g., the display module 160 of FIG. 1). In an embodiment, the display 261 may be positioned on the front surface 210a of the electronic device 201. In an embodiment, the display 261 may be visually exposed through at least a portion (e.g., the first periphery regions 212a-1, the second periphery regions 212a-2, and the third periphery regions 212a-3) of the front plate 211a. In an embodiment, the display 261 may have a shape that is substantially the same as the shape of an outer edge of the front plate 211a. Although not shown in the drawings, the display 261, according to an embodiment, may include a touch screen panel (TSP), a pressure sensor, and/or a digitizer (not shown) for detecting a stylus pen.

In an embodiment, the display 261 may include a screen display region 261a that is visually exposed to the outside of the electronic device 201 to display content through a pixel or a plurality of cells. In an embodiment, the screen display region 261a may include a sensing region 261a-1 and/or a camera region 261a-2. The sensing region 261a-1 may overlap at least a portion of the screen display region 261a. The sensing region 261a-1 may allow transmission of an input signal related to a sensor module (e.g., the sensor module 176 of FIG. 1). The sensing region 261a-1 may display content together with the screen display region 261a that does not overlap the sensing region 261a-1.

In an embodiment, the camera region 261a-2 may overlap at least a partial region of the screen display region 261a. The camera region 261a-2 may expose a lens of a first camera module 280a (e.g., the camera module 180 of FIG. 1) disposed to face the front surface of the electronic device 201. For example, the camera region 261a-2 may allow transmission of an optical signal (e.g., light) related to the camera module 280a. In an embodiment, the camera region 261a-2 may display content, similarly to the screen display region 261a that does not overlap the camera region 261a-2. For example, the camera region 261a-2 may display the content while the first camera module 280a is not operating.

In an embodiment, the electronic device 201 may include the sensor module 276. The sensor module 276 may sense a signal applied to the electronic device 201. The sensor module 276 may be positioned, for example, on the front surface 210a of the electronic device 201. The sensor module 276 may be disposed on the electronic device 201 to correspond to the sensing region 261a-1 of the screen display region 261a. For example, the sensor module 276 may also be disposed to perform its function in the inner space of the electronic device 201 without being visually exposed through the display 261. The sensor module 276 may receive an input signal transmitted through the sensing region 261a-1 and generate an electrical signal based on the received input signal. For example, the input signal may have a designated physical quantity (e.g., heat, light, temperature, sound, pressure, or ultrasound). In an embodiment, the input signal may include a signal related to biometric information (e.g., a fingerprint, a voice, and the like) of a user.

In an embodiment, the electronic device 201 may include the camera module 280a or 280b (e.g., the camera module 180 of FIG. 1). In an embodiment, the camera module 280a or 280b may include the first camera module 280a and the second camera module 280b. In an embodiment, the electronic device 201 may include a flash 280c disposed near the first camera module 280a and the second camera module 280b.

In an embodiment, the first camera module 280a may be disposed on the front surface 210a of the housing 210 to expose a lens, and may receive an optical signal from the front side (e.g., the +Z direction) of the electronic device 201. The second camera module 280b may be disposed on the rear surface 210b of the housing 210 to expose a lens, and may receive an optical signal from the rear side (e.g., the -Z direction) of the electronic device 201. In an embodiment, at least a portion of the first camera module 280a may be disposed in the housing 210 so as to be covered through the display 261. For example, the first camera module 280a may include an under display camera (UDC). In an embodiment, the first camera module 280a may receive an optical signal transmitted through the camera region 261a-2. In an embodiment, the second camera module 280b may include a plurality of cameras (e.g., dual cameras, triple cameras, or quad cameras). In an embodiment, the flash 280c may include a light-emitting diode or a xenon lamp.

In an embodiment, the electronic device 201 may include an input module 250 (e.g., the input module 150 of FIG. 1). The input module 250 may receive a manipulation signal from a user. The input module 250 may include, for example, at least one key input device disposed to be exposed on the side surface 211c of the housing 210.

In an embodiment, the electronic device 201 may include a connecting terminal 278 (e.g., the connecting terminal 178 of FIG. 1). In an embodiment, the connecting terminal 278 may be disposed on the outer circumferential surface of the housing 210. The electronic device 201 may be connected by wire to an external device (e.g., another electronic device or an external power supply) through the connecting terminal 278.

The electronic device, according to an embodiment, may be one of various types of electronic devices. The electronic device may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

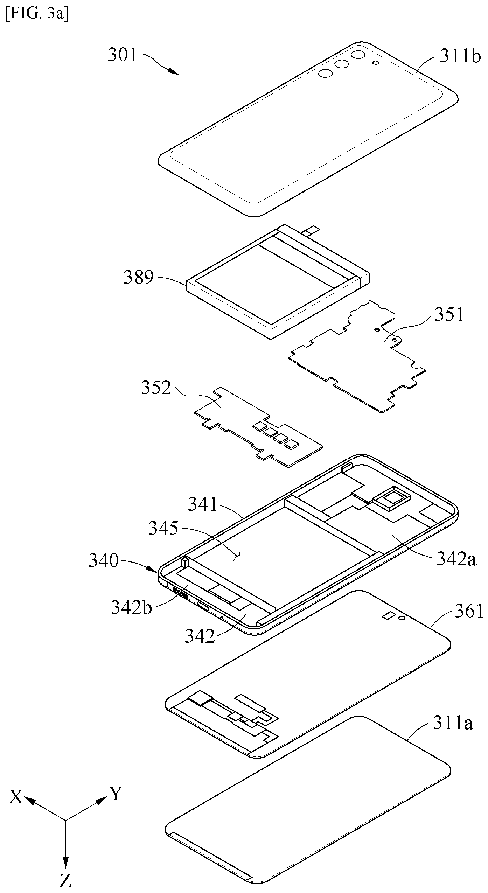

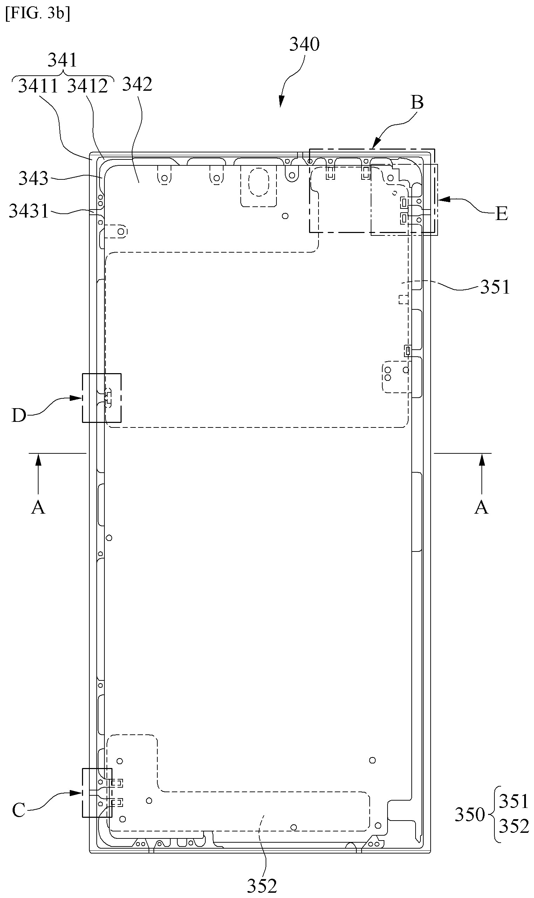

FIG. 3a is an exploded perspective view of an electronic device according to an embodiment. FIG. 3b is a diagram illustrating a metal housing of an electronic device according to an embodiment.

Referring to FIGS. 3a and 3b, an electronic device 301 (e.g., the electronic device 201 of FIG. 2a), according to an embodiment, may include a front plate 311a forming the front surface (e.g. the front surface 210a of FIG. 2a) of the electronic device 301, a rear plate 311b (e.g., the rear plate 211b of FIG. 2a) forming the rear surface (e.g., the rear surface 210b of FIG. 2a), and a metal housing 340 (e.g., the metal housing 240 of FIG. 2a) forming the side surface (e.g., the side surface 211c of FIG. 2a) of the electronic device 301.

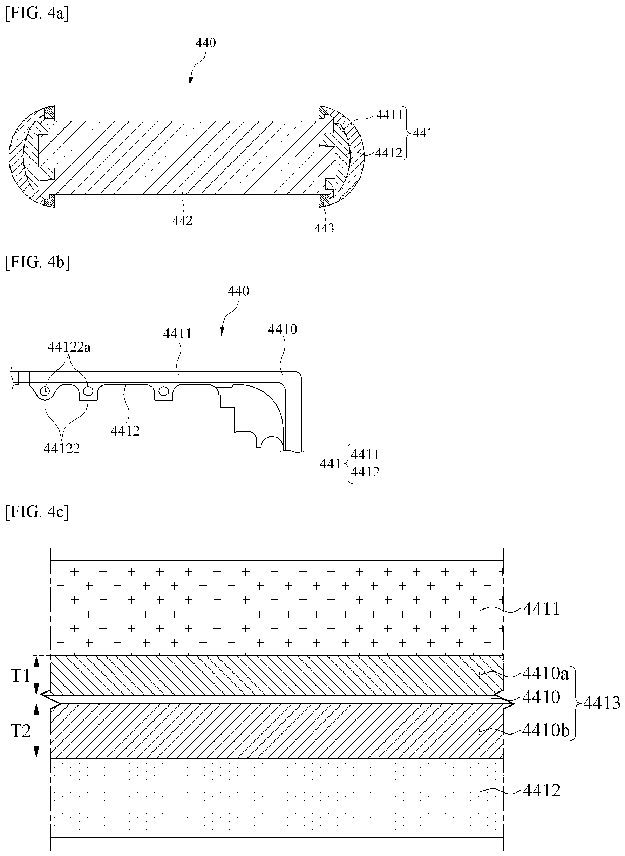

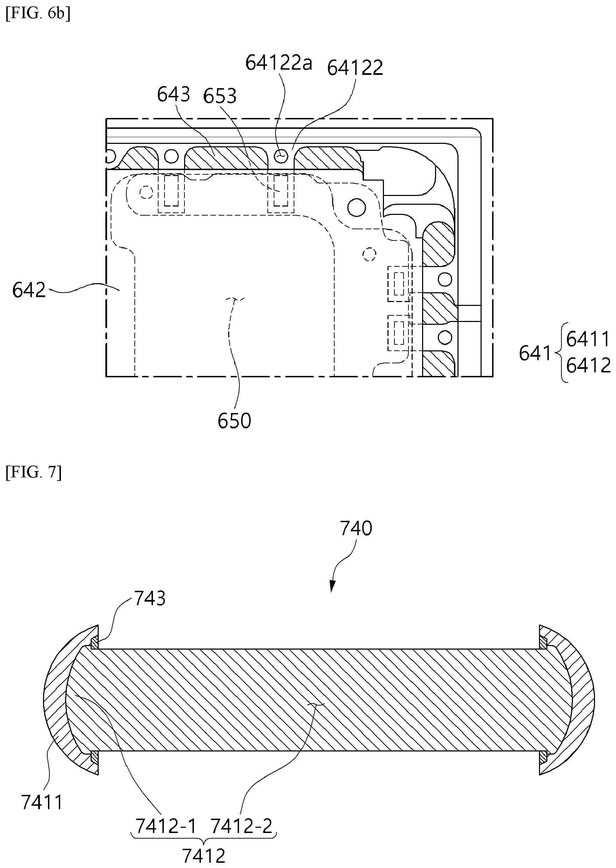

In an embodiment, the metal housing 340 may include a side frame 341 surrounding the side surface of the electronic device 301. In an embodiment, the side frame 341 may include a metal material and may function as an antenna radiator of the electronic device 301. In an embodiment, the metal housing 340 may include a bracket 342 (or a bracket portion or support portion) that is connected to the interior of the side frame 341 and supports the parts of the electronic device 301 inside the electronic device 301. In an embodiment, the bracket 342 may be formed integrally with the side frame 341 (e.g., a bracket portion 7412-2 of FIG. 7), or manufactured separately from the side portion 341 and connected to the side frame 341 (e.g., the bracket 342 of FIG. 4a). In an embodiment, the side frame 341 may form a plurality of electrically separated conductive regions along the side surface of the electronic device 301. In an embodiment, the side frame 341 may be formed of one or more metal materials and/or polymer materials having conductivity. In an embodiment, the bracket 342 may be formed of a conductive metal and/or polymer material, similar to the side frame 341. In an embodiment, when the bracket 342 is directly connected to the side frame 341, the bracket 342 may form an electrical path leading from a metal member (e.g., a conductive region) of the side frame 341 to ground.

In an embodiment, the electronic device 301 may include one or more circuit boards (PCBs). For example, the electronic device 301 may include a first circuit board 351 (or a main circuit board) and a second circuit board 352 (or a sub-circuit board). In an embodiment, the first circuit board 351 and the second circuit board 352 may be disposed inside the electronic device 301, for example, on the second support structure 342. At least one circuit board 351 or 352 may be connected to the bracket 342 through ground. In an embodiment, the first circuit board 351 may be accommodated in a first board slot 342a formed by the bracket 342. In an embodiment, the second circuit board 352 may be accommodated in a second board slot 342b formed by the bracket 342. In an embodiment, the circuit board 351 or 352 may be a rigid PCB or at least a partially bendable flexible PCB (FPCB).

In an embodiment, the electronic device 301 may include a battery 389 disposed therein. A battery 389may be disposed in a battery slot 345 formed in the support portion 342.

The metal housing 340, according to an embodiment, may include the side frame 341, the bracket 342, and an insulating member 343.

In an embodiment, the side frame 341 may form the side surface of the electronic device 301. The side frame 341 may include a first metal member 3411, which is exposed to the outside along the side surface of the electronic device 301, and a second metal member 3412, which is connected to the first metal member 3411 along the inner perimeter of the first metal member 3411. In an embodiment, the first metal member 3411 may include a first metal material, and the second metal member 3412 may include a second metal material. In an embodiment, the first metal material forming the first metal member 3411 may have a relatively higher hardness compared to the second metal material forming the second metal member 3412. In an embodiment, the first metal member 3411 and the second metal member 3412 may be integrally connected to each other. For example, the first metal member 3411 and the second metal member 3412 may be connected to each other through diffusion bonding. In this case, the first metal material forming the first metal member 3411 and the second metal material forming the second metal member 3412 may be bonded together by material diffusion of each metal material.

In an embodiment, the first metal member 3411 and the second metal member 3412 may be formed by a metal injection molding (MIM) technique. For example, the first metal member 3411 and the second metal member 3412 may be formed by continuously injecting the first metal material and the second metal material into a mold. For example, the first metal member 3411 may be formed by sintering first metal powder. For example, the second metal member 3412 may be formed by sintering second metal powder. In an embodiment, the side frame 341 may be formed by bonding the first metal powder of the first metal member 3411 to the second metal powder of the second metal member 3412 before sintering. For example, the side frame 341 may be formed in such a way that the first metal member 3411 is first metal injection molded, and the second metal member 3412 is second metal injection molded before the first metal member 3411 is debinded.

In an embodiment, the bracket 342 may be connected to the inside of the side frame 341. For example, at least a portion of the bracket 342 (e.g., an edge portion) may be integrally connected to the first metal member 3411 and/or the second metal member 3412 of the side frame 341 through bonding or connected in an assembly manner.

In an embodiment, the insulating member 343 may be connected to the side frame 341. For example, the insulating member 343 may be connected to the side frame 341 along the perimeter of the side frame 341 to cover at least a portion of the first metal member 3411 and the second metal member 3412. In an embodiment, the insulating member 343 may be connected to the side frame 341 to cover the bonding portion of the first metal member 3411 and the second metal member 3412 so that the bonding portion of the first metal member 3411 and the second metal member 3412 of the side frame 341 is not directly exposed to the outside. In an embodiment, the insulating member 343 may include an insulating material. The insulating member 343 may include a segment portion 3431 that divides the side frame 341 into a plurality of electrically separated conductive regions in the perimeter direction, that is, along the side of the electronic device 301.

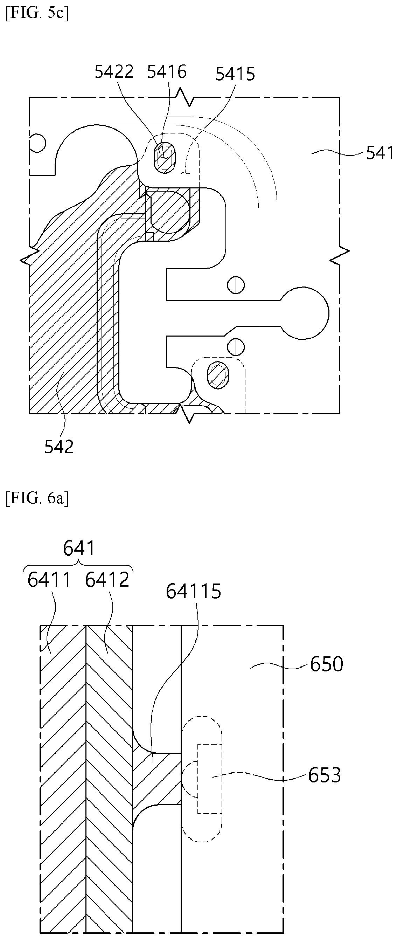

In an embodiment, the metal housing 340 may support the circuit board 350. For example, the circuit board 350 may be disposed on the bracket 342. In an embodiment, when a plurality of circuit boards 350 is provided, for example, when the circuit board 350 includes the first circuit board 351 and the second circuit board 352, the first circuit board 351 and the second circuit board 352 may be spaced apart from each other at different positions on the bracket 342. In an embodiment, each circuit board 350 may be fixed in position by screw connection or the like to the bracket 342. In an embodiment, the first circuit board 351 and the second circuit board 352 may be electrically connected to each other through a connecting board (e.g., an FPCB) (not shown). In an embodiment, a wireless communication circuit (e.g., the wireless communication module 192 of FIG. 1) may be disposed on the first circuit board 351 or the second circuit board 352. In an embodiment, each circuit board 350 may be electrically connected to the side frame 341 of the metal housing 340 to form an electrical path between the wireless communication circuit and a conductive region formed by the side frame 341. For example, the circuit board 350 may include one or more contact members (e.g., a contact member 653 of FIG. 6a) that are disposed on the surface of the circuit board 350 and electrically connected through a wireless communication circuit and a signal line, and may be electrically connected to the side frame 341 through the contact members.

FIG. 4a is a cross-sectional view of an example metal housing along line A-A of FIG. 3b for illustrating the structure of a metal housing according to an embodiment. FIG. 4b is a diagram of an example shape of region B of FIG. 3b for illustrating a side frame according to an embodiment. FIG. 4c is an enlarged view of a bonding portion of a first metal member and a second metal member for illustrating an external region according to an embodiment.

Referring to FIGS. 4a to 4c, a metal housing 440 (e.g., the metal housing 340 of FIG. 3b), according to an embodiment, may be formed in a structure in which a first metal member 4411 (e.g., the first metal member 3411 of FIG. 3b), a second metal member 4412 (e.g., the second metal member 3412 of FIG. 3b), a bracket 442 (e.g., the bracket 342 of FIG. 3b), and an insulating member 443 (e.g., the insulating member 343 of FIG. 3b) are interconnected.

In an embodiment, the first metal member 4411 and the second metal member 4412 may be integrally connected to each other to form a side frame 441 (e.g., the side frame 341 of FIG. 3a). In an embodiment, the first metal member 4411 and the second metal member 4412 may form a side surface of an electronic device (e.g., the electronic device 401 of FIG. 3a).

In an embodiment, the first metal member 4411 may be directly exposed to the outside, as shown in FIG. 4a, to form the exterior of the electronic device. In an embodiment, the second metal member 4412 may be connected to the inside of the first metal member 4411. In an embodiment, the second metal member 4412 may function as a power supply part that receives an electrical signal from a wireless communication circuit (e.g., the wireless communication module 192 of FIG. 1) or as a heat dissipation part that dissipates heat generated inside the electronic device 401.

In an embodiment, the bracket 442 may be connected to the interior of the side frame 441, for example, to the interior of the second metal member 4412. In an embodiment, the bracket 442 may be connected to the second metal member 4412 along the inner perimeter of the second metal member 4412.

In an embodiment, the insulating member 443 may form an insulating material, and the insulating member 443 may be connected to the side frame 441 along the perimeter of the side frame 441 to cover at least a portion of the first metal member 4411 and the second metal member 4412. In an embodiment, the insulating member 443 may be bonded to the first metal member 4411 and the second metal member 4412. For example, the insulating member 443 may be injection bonded to the first metal member 4411 and the second metal member 4412. In an embodiment, the insulating member 443 may be structurally coupled to the side frame 441. For example, as shown in FIG. 4b, the second metal member 4412 may include a contact portion 44125 that inwardly protrudes and through which a through hole 44125a is formed. In an embodiment, at least a portion of the insulating member 443 may be anchored and coupled within the through hole 44125a formed in the second metal member 4412.

In an embodiment, the first metal member 4411 may include a first metal material, and the second metal member 4412 may include a second metal material. In an embodiment, the first metal material forming the first metal member 4411 may have a higher surface hardness than the second metal material forming the second metal member 4412. For example, the first metal member 4411 may be directly exposed to the outside, then may be formed of a material having higher hardness and corrosion resistance than the second metal member 4412. In an embodiment, the second metal material may have higher thermal conductivity and conductivity compared to the first metal material.

In an embodiment, the first metal material may include at least one material among titanium, stainless steel, or aluminum. For example, the second metal material may include at least one material among stainless steel, a copper alloy, an aluminum-magnesium alloy, an aluminum-chromium alloy, an aluminum-titanium alloy, magnesium, or zinc. In an embodiment, the first metal material and the second metal material may be combined in various forms. For example, when the first metal material includes titanium, the second metal material may include stainless steel. For example, when the first metal material includes stainless steel, the second metal material may include at least one material among stainless steel, an aluminum alloy, a copper alloy, nickel, and cobalt of a different series from the first metal material. For example, when the first metal material includes aluminum, the second metal material may include at least one material among aluminum, magnesium, or zinc having a different grade from the first metal material.

In an embodiment, the melting point of the first metal material forming the first metal member 4411 may be higher than the melting point of the second metal material forming the second metal member 4412. In an embodiment, the difference in melting points between the first metal material and the second metal material may be, for example, 300 degrees or less.

In an embodiment, the first metal member 4411 and the second metal member 4412 may be integrally connected to each other through diffusion bonding. In an embodiment, a bonding region 4413 formed around a bonding interface 4410 as shown in FIG. 4c may be formed at the bonding portion of the first metal member 4411 and the second metal member 4412. In an embodiment, the bonding region 4413 may be formed by mixing the first metal material forming the first metal member 4411 and the second metal material forming the second metal member 4412. In an embodiment, the bonding region 4413 may include a first diffusion layer 4410a formed on at least a portion of the first metal member 4411 from the bonding interface 4410, and a second diffusion layer 4410b formed on at least a portion of the second metal member 4412 from the bonding interface 4410. In an embodiment, the first diffusion layer 4410a may be formed by the metal particles of the second metal material forming the second metal member 4412 diffusing into the metal particles of the first metal material forming the first metal member 4411. The second diffusion layer 4410b may be formed by the metal particles of the first metal material forming the first metal member 4411 diffusing into the metal particles of the second metal material forming the second metal member 4412. The first metal member 4411 and the second metal member 4412 may be integrally bonded together by a bonding region.

In an embodiment, as shown in FIG. 4c, based on the bonding interface 4410, a first thickness T1 of the first diffusion layer 4410a may be less than or equal to a second thickness T2 of the second diffusion layer 4410b. For example, the first thickness T1 from the bonding interface 4410 to the boundary of the first diffusion layer 4410a may be less than the second thickness T2 from the bonding interface 4410 to the boundary of the second diffusion layer 4410b. In an embodiment, the ratio of the first thickness T1 of the first diffusion layer 4410a to the second thickness T2 of the second diffusion layer 4410b may vary depending on the difference in melting points between the first metal material and the second metal material.

In an embodiment, the insulating member 443 may be connected to the side frame 441 to cover at least a portion of the first metal member 4411 and the second metal member 4412 so that the bonding region of the first metal member 4411 and the second metal member 4412 is not exposed to the outside.

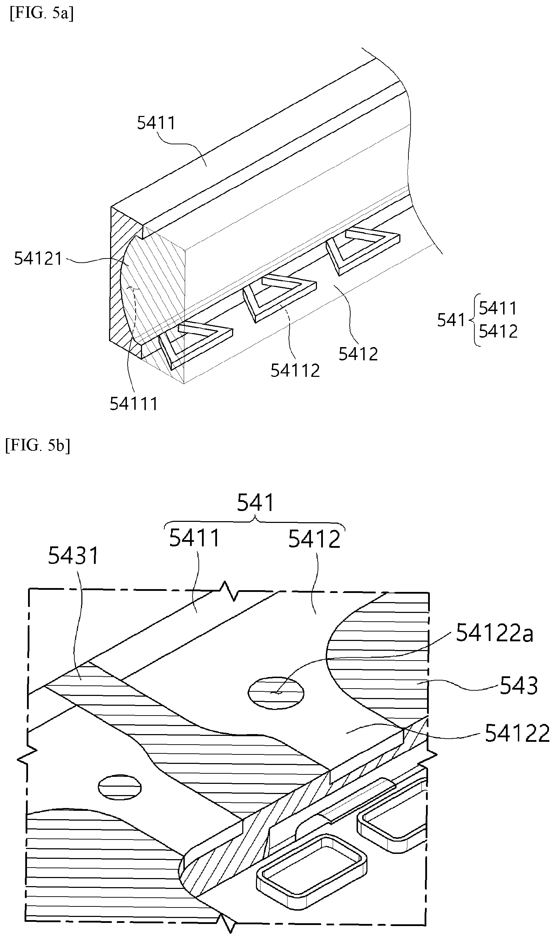

FIG. 5a is a partial cross-sectional perspective view of a coupling structure of a first metal member and a second metal member, according to an embodiment. FIG. 5b is a diagram of an example shape of region C of FIG. 3b for illustrating a coupling structure of a side frame and an insulating member, according to an embodiment. FIG. 5c is a diagram of an example shape of region E of FIG. 3b for illustrating a coupling structure of a side frame and a bracket, according to an embodiment.

Referring to FIG. 5a, in an embodiment, a first metal member 5411 (e.g., the first metal member 3411 of FIG. 3b) and a second metal member 5412 (e.g., the second metal member 3412 of FIG. 3b) may improve the bonding strength according to diffusion bonding through a structural bonding technique.

In an embodiment, the first metal member 5411 may include a recess 54111 formed in at least a portion of an inner surface of the first metal member 5411 facing the second metal member 5412. In an embodiment, the recess 54111 may be formed in an undercut shape. In an embodiment, the second metal member 5412 may include an insertion portion 54121 formed on an outer surface facing the first metal member 5411 and engaging with and connected to the recess 54111 formed on the inner surface of the first metal member 5411. In an embodiment, the coupling structure of the recess 54111 and the insertion portion 54121 may be formed in a straight-line extending portion of a side frame (e.g., the side frame 341 of FIG. 3b).

In an embodiment, the first metal member 5411 and the second metal member 5412 may be connected to each other through an anchor structure. For example, as illustrated in FIG. 5a, the first metal member 5411 may include an anchor portion 54112 that extends into the interior of the second metal member 5412 and is formed to penetrate at least a portion of the second metal member 5412, and the second metal member 5412 may be anchored to the first metal member 5411 through the anchor portion 54112.

Referring to FIG. 5b, in an embodiment, the side frame may include the first metal member 5411 (e.g., the first metal member 3411 of FIG. 3b) and the second metal member 5412 (e.g., the second metal member 3412 of FIG. 3b) connected to the interior of the first metal member 5411.

In an embodiment, an insulating member 543 (e.g., the insulating member 343 of FIG. 3b) may be connected to the interior of the side frame to cover at least a portion (e.g., a bonding region) of the first metal member 5411 and the second metal member 5412. In an embodiment, the insulating member 543 may include one or more segment portions 5431 (e.g., the segment portion 3431 of FIG. 3b) that divide the side frame 541 into a plurality of electrically separated conductive parts. For example, the first metal member 5411 and the second metal member 5412 may be at least partially cut, and the portion of the first metal member 5411 and the second metal member 5412 that is cut may be occupied by the segment portion 5431 in which the insulating member 543 is formed.

In an embodiment, the insulating member 543 (e.g., the insulating member 343 of FIG. 3b) may be structurally coupled to the side frame 541 to strengthen the bonding strength to the side frame 541 at a portion where the segment portion 5431 is formed. For example, the second metal member 542 may include a contact portion 54112 (or an anchor portion) that protrudes inwardly (e.g., in the direction that is opposite to the first metal member 541) from a portion adjacent to the segment portion 5431 (e.g., both sides of the segment portion) and has a through hole 54122a formed therein. At least a portion of the insulating member 543 may be anchored and fixed within the through hole 54122a formed in the contact portion 54112.

Referring to FIG. 5c, in an embodiment, the bracket 542 may be connected to the interior of the side frame 541. In an embodiment, the side frame 541 may include a bonding portion 5415, wherein at least a portion of the bonding region 5415 may extend into the interior of the electronic device (e.g., the electronic device 301 of FIG. 3a). The bonding portion 5415 may overlap at least a portion of the bracket 542. In an embodiment, the bracket 542 may be bonded to the bonding portion 5415 of the side frame 541. For example, the bracket 542 may be integrally connected to the bonding portion 5415 of the side frame 541 through laser bonding or welding.

In an embodiment, the side frame 541 may include one or more guide grooves 5416 formed through the bonding portion 5415, and the bracket 542 may include one or more guide members 5422 engaging with and inserted to each of the guide grooves 5416. In an embodiment, when the bracket 542 is positioned at an aligned position (e.g., a correct assembly position) with respect to the side frame 541, the guide members 5422 of the bracket 542 may engage with the guide grooves 5416 of the side frame 541. For example, the bonding position of the bracket 542 and the side frame 541 may be guided through the engagement of the guide members 5422 with the guide grooves 5416.

FIG. 6a is a diagram of an example shape of region D of FIG. 3b for illustrating a connection structure between a first metal member and a contact member, according to an embodiment. FIG. 6b is a diagram of an example shape of region B of FIG. 3b for illustrating a connection structure between a second metal member and a contact member, according to an embodiment.

Referring to FIGS. 6a and 6b, in an embodiment, a side frame 641 (e.g., the side frame 341 of FIG. 3b) may be electrically connected to a PCB 650 (e.g., the PCB 350 of FIG. 3b). In an embodiment, the PCB 650 may include one or more contact members 653 that are electrically connected to a wireless communication circuit (e.g., the wireless communication module 192 of FIG. 1). In an embodiment, each of the contact members 653 may be disposed on the surface of the PCB 650 and may be electrically connected to one another through the wireless communication circuit and a signal line. Each of the contact members 653 may function as a power supply point that applies an electrical signal to a conductive region of the side frame 641, or as a grounding point that receives an electrical signal from the conductive region.

In an embodiment, the side frame 641 may include one or more contact portions 64115 and 54125 that are directly or indirectly connected to one or more contact members 653. The contact portions 64115 and 54125 may be connected, for example, to be in contact with a contact member 653 to form an electrical path with the wireless communication circuit.

In an embodiment, as shown in FIG. 6a, the side frame 641 may be connected to the contact member 653 to form a direct electrical path through a first metal member 6411. For example, the first metal member 6411 may include one or more first contact portions 64115 extending into the interior of the electronic device (e.g., the interior of the electronic device 301 of FIG. 3b). The first contact portion 64115 may extend across the second metal member 6412 toward the PCB 650. In an embodiment, the first contact portion 64115 may be in contact with the contact member 653.

In an embodiment, when the first metal member 6411 is in direct contact with the contact member 653 through the first contact portion 64115, the first metal material forming the first metal member 6411 and the third metal material forming the contact member 653 in contact with the first contact portion 64115 may be selected such that a potential difference causing galvanic corrosion is less than or equal to a set value. For example, the first metal material and the third metal material may have a metal potential difference of 0.2 or less. For example, in order to reduce galvanic corrosion caused by heterogeneous metal contact between the first contact portion 64115 of the first metal member 6411 formed of the first metal material and the contact member 653 formed of the third metal material and in contact with the first contact portion 64115, the first metal material and the third metal material may be selected to have a potential difference that is less than or equal to a set value.

In an embodiment, as shown in FIG. 6b, the side frame 641 may be connected to the contact member 653 to form a direct electrical path through the second metal member 6412. For example, the second metal member 6412 may include one or more second contact portions 64112 extending into the interior of the electronic device (e.g., the interior of the electronic device 301 of FIG. 3b). The second contact portion 64112 may extend across the insulating member 643 toward the PCB 650. In an embodiment, the second contact portion 64112 may be in direct contact with the contact member 653.

FIG. 7 is a cross-sectional view of an example metal housing along line A-A of FIG. 3b for illustrating a metal housing according to an embodiment. In an embodiment, unless particularly stated otherwise, the configuration of the metal housing described with reference to FIGS. 3a to 6b may be applied in the same way to a metal housing of FIG. 7.

Referring to FIG. 7, a metal housing, according to an embodiment, may include a first metal member 7411, a second metal member 7412, and an insulating member 743.

In an embodiment, the first metal member 7411 may be exposed to the outside to form a side surface of an electronic device (e.g., the electronic device 301 of FIG. 3a). In an embodiment, the first metal member 7411 may be formed of a first metal material. In an embodiment, the second metal member 7412 may be bonded to the first metal member 7411 along the inner perimeter of the first metal member 9411. In an embodiment, the second metal member 7412 may be formed of a second metal material. In an embodiment, the second metal member 7412 may include a bracket portion 7412-2 and a bonding portion 7412-1 bonded to the inner surface of the first metal member 7411 along the perimeter of the bracket portion 7412-2. In an embodiment, the bracket portion 7412-2 (e.g., the bracket 342 of FIG. 3b) may support each part of the electronic device inside the electronic device. For example, a PCB (e.g., the PCB 350 of FIG. 3b) may be disposed on the bracket portion 7412-2.

In an embodiment, the bonding portion 7412-1 of the second metal member 7412 may be integrally bonded to the first metal member 7411. For example, the bonding portion 7412-1 and the first metal member 7411 may be bonded to each other by diffusion bonding. In an embodiment, a bonding region (e.g., the bonding region 4413 of FIG. 4c) may be formed between the bonding portion 7412-1 of the first metal member 7411 and the second metal member 7412 with a bonding interface (e.g., the bonding interface 3410 of FIG. 4c) in between. For example, the bonding region may be formed by mixing the first metal material forming the first metal member 7411 and the second metal material forming the second metal member 7412. In an embodiment, the bonding region may include a first diffusion layer (e.g., the first diffusion layer 4410a of FIG. 4c) formed on at least a portion of the first metal member 7411 from the bonding interface (e.g., the bonding interface 4410 of FIG. 4c) and a second diffusion layer (e.g., the second diffusion layer 4410b of FIG. 4c) formed on at least a portion of the bonding portion 7412-1 of the second metal member 7412 from the bonding interface. In an embodiment, based on the bonding interface, the second diffusion layer may have a greater thickness than the first diffusion layer.

In an embodiment, the insulating member 743 (e.g., the insulating member 343 of FIG. 3c) may be connected to the first metal member 7411 and the second metal member 7412 to cover a bonding region (e.g., the bonding region 4413 of FIG. 4c). In an embodiment, the insulating member 743 may form one or more segment portions (e.g., the segment portion 3431 of FIG. 3b) that divide the bonding portion 7412-1 of the first metal member 7411 and the second metal member 7412 along the side surface of the electronic device into a plurality of electrically separated conductive regions.

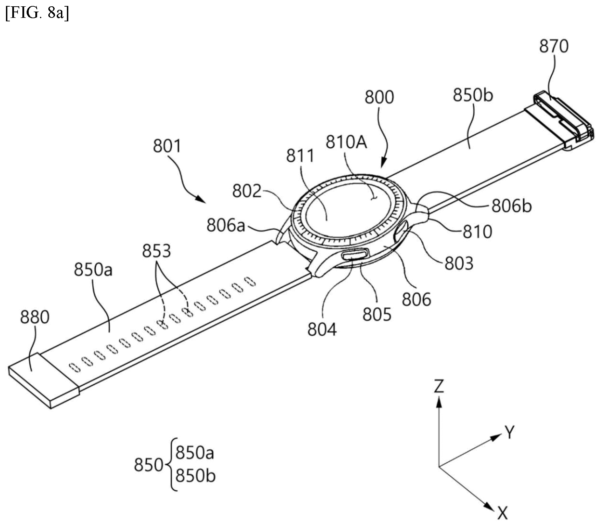

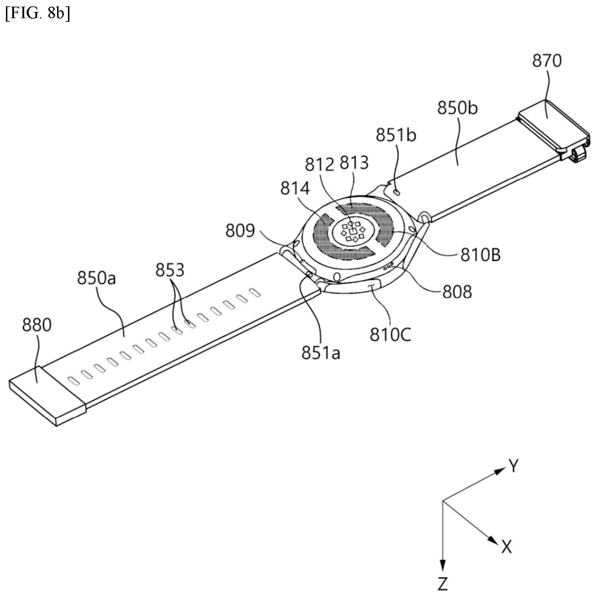

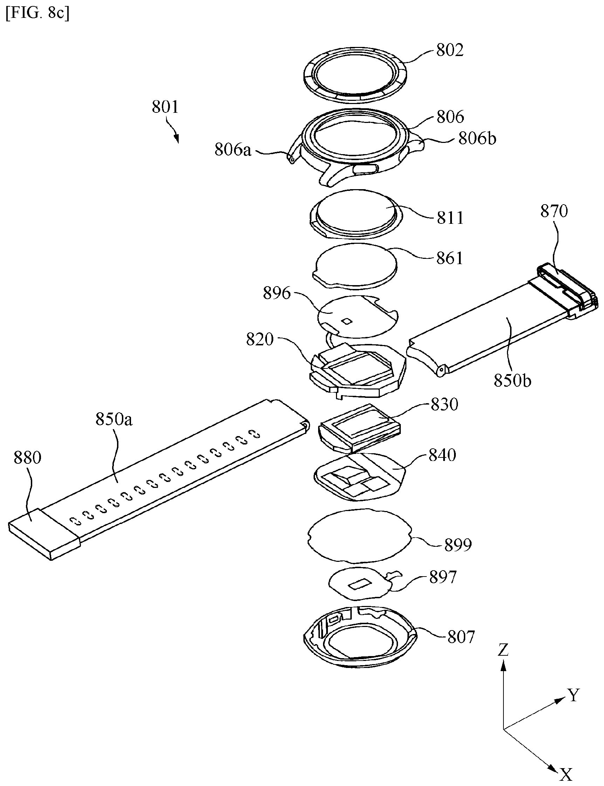

FIG. 8a is a front perspective view of a wearable electronic device according to an embodiment. FIG. 8b is a rear perspective view of a wearable electronic device according to an embodiment. FIG. 8c is an exploded perspective view of a wearable electronic device according to an embodiment.

Referring to FIGS. 8a to 8c, a wearable electronic device 801, according to an embodiment, may include a main body 800 of the wearable electronic device 801, a strap 850 connected to the main body 800 and configured to detachably attach the wearable electronic device 801 to a portion of the body (e.g., wrist or ankle) of a user, and a strap fastening structure 870 connected to the strap 850.

In an embodiment, the main body 800 may include a housing structure forming an exterior. In an embodiment, the housing structure (e.g., the electronic device 101 of FIG. 1) may include a first surface (or a front surface) 810A, a second surface (or a rear surface) 810B, and a side surface 810C surrounding the space between the first surface 810A and the second surface 810B. In an embodiment, the housing structure may be a structure that forms a portion of the first surface 810A, the second surface 810B, and the side surface 810C of FIG. 2a. In an embodiment, the first surface 810A may be formed of a front plate 811 (e.g., a glass plate or a polymer plate including various coating layers) of which at least a portion is substantially transparent. In an embodiment, the second surface 810B may be formed of a rear plate 807 that is substantially opaque. In an embodiment, the rear plate 807 may be formed of, for example, coated or colored glass, ceramic, polymer, metal (e.g., aluminum, stainless steel, or magnesium), or a combination of at least two of the materials. In an embodiment, the side surface 810C may be coupled to the front plate 811 and the rear plate 807 and may be formed by a side frame 806 (or "side bezel structure" or "side member") 806 including metal and/or polymer. In an embodiment, the rear plate 807 and the side frame 806 may be formed as separate structures and then coupled to each other. Alternatively, the rear plate 807 and the side frame 806 may be integrally formed and may include the same material (e.g., a metal material such as aluminum).

In an embodiment, various components for operating the wearable electronic device 801 may be disposed in the main body 800. For example, the wearable electronic device 801 may include at least one of a display 861, audio modules 805 and 208, a sensor module 812, key input devices 802, 203, and 204, and a connector hole 809. In an embodiment, at least one (e.g., the key input devices 802, 203, and 204, the connector hole 809, or the sensor module 812) of the components of the wearable electronic device 801 described above may be omitted or replaced with other components, and the wearable electronic device 801 may additionally include other components that are not mentioned.

In an embodiment, the display 861 may be exposed on the first surface 810A of a housing 810, for example, through a significant portion of the front plate 811. In an embodiment, the display 861 may be formed in a shape corresponding to the shape of the front plate 811, or may be formed in various shapes such as a circle, an ellipse, or a polygon. In an embodiment, the display 861 may be coupled to or disposed adjacent to a touch sensing circuit, a pressure sensor that detects touch intensity (pressure), and/or a fingerprint sensor that recognizes a user fingerprint.

In an embodiment, the audio modules 805 and 208 may include a microphone hole 805 and a speaker hole 808. In an embodiment, a microphone for obtaining external sound may be disposed in the microphone hole 805, and in some embodiments, a plurality of microphones may be disposed in the microphone hole 805 to detect the direction of sound. In some embodiments, the speaker hole 808 and the microphone hole 805 may be implemented as a single hole, and a speaker (e.g., a piezo speaker) with the speaker hole 808 omitted may be applied to the wearable electronic device 801.

In an embodiment, the sensor module 812 may generate an electrical signal or a data value corresponding to an operating state of the inside (e.g., the inside of the main body 800) of the wearable electronic device 801 or an external environment state. In an embodiment, the sensor module 812 may include, for example, a biosensor module (e.g., a heart rate monitor (HRM) sensor) disposed on the second surface 810B of the housing 810. In an embodiment, the wearable electronic device 801 may further include at least one of other sensor modules not shown, for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

In an embodiment, the sensor module 812 may include electrode regions 813 and 214 that form a portion of the surface of the main body 800 and a biosignal detection circuit (not shown) electrically connected to the electrode regions 813 and 214. For example, the electrode regions 813 and 214 may include the first electrode region 813 and the second electrode region 814 disposed on the second surface 810B of the housing 810. The sensor module 812 may be configured such that the electrode regions 813 and 214 obtain an electrical signal from a body part of the user, and the biosignal detection circuit detects biometric information of the user based on the obtained electrical signal.

In an embodiment, the key input devices 802, 203, and 204 may include a wheel key 802 disposed on the first surface 810A of the housing 810 and rotatable in at least one rotation direction, and/or side key buttons 803 and 204 disposed on the side surface 810C of the housing 810. In an embodiment, the wheel key 802 may be formed in a shape corresponding to the shape of the front plate 811. In some embodiments, the wearable electronic device 801 may not include some or all of the key input devices 802, 203, and 204 described above, and the key input devices 802, 203, and 204 that are not included may be implemented in other forms, such as a soft key, on the display 861.

In an embodiment, the connector hole 809 may accommodate a connector (e.g., a USB connector) for transmitting and receiving power and/or data with an external electronic device. In an embodiment, the wearable electronic device 801 may include another connector hole (not shown) for transmitting and receiving an audio signal with the external electronic device. In an embodiment, a connector cover (not shown) may be disposed in the connector hole 809 to block or reduce the inflow of foreign matter into the connector hole 809.

In an embodiment, the strap 850 may include a first strap 850a and a second strap 850b. In an embodiment, the first strap 850a may be detachably connected to a first portion 806a of the housing 810 through a first locking member 851a. The second strap 850b may be detachably connected to a second portion 806b of the housing 810 through a second locking member 851b. In an embodiment, the strap 850 may be formed of a metal material (e.g., metal) to which magnetism may act.

In an embodiment, a fastening groove 853 may be formed in the strap 850. The fastening groove 853 may be formed concavely on the surface (e.g., the surface facing the -Z direction of FIG. 2a) of the first strap 850a. In an embodiment, a plurality of fastening grooves 853 may be provided, and the plurality of fastening grooves 853 may be spaced apart at regular intervals along the longitudinal direction of the first strap 850a (e.g., the longitudinal direction of the first strap 850a parallel to the Y-axis direction of FIG. 2a). Although the drawings illustrate that the fastening groove 853 is formed only in the first strap 850a, this is only an example, and the fastening groove 853 may be formed on the surface of both the first strap 850a and the second strap 850b.

In an embodiment, a strap fastening structure 870 may be connected to the strap 850. The strap fastening structure 870 may be configured to fasten the strap 850 to a portion of the body (e.g., wrist or ankle) of a user to secure the main body 800 of the wearable electronic device 801 to the body of the user. For example, the strap fastening structure 870 may be connected to an end of the first strap 850a (e.g., the end of the first strap 850a facing the +Y direction of FIG. 2a) and configured to fasten the first strap 850a and the second strap 850b to each other. The strap fastening structure 870 may be configured to restrict the movement between the first strap 850a and the second strap 850b while the first strap 850a and the second strap 850b are in close contact with a body part of the user, thereby stably maintaining the wearing state of the wearable electronic device 801 on the body of the user. In an embodiment, a fastening member 880 may be connected to an end of the first strap 850a (e.g., the end of the first strap 850a facing the -Y direction of FIG. 2a). In an embodiment, the fastening member 880 may include a magnetic material. When the second strap 850b includes a magnetic metal material, the fastening member 880 may be attached to the second strap 850b.

In an embodiment, the wearable electronic device 801 may further include a first antenna 896, a second antenna 897, a bracket 820 (e.g., a support member), a battery 830, a PCB 840, a sealing member 899, and a rear plate 807 disposed on the main body 800.

In an embodiment, the bracket 820 may be disposed in the main body 800 and connected to the side frame 806, or may be formed integrally with the side frame 806. In an embodiment, the support member 820 may be formed of, for example, a metal material and/or a non-metal material (e.g., a polymer). The display 861 may be connected to one surface of the support member 820, and the PCB 840 may be connected to the other surface.

In an embodiment, a processor, memory, and/or an interface may be disposed on the PCB 840. The processor may include, for example, one or more of a CPU, an AP, a GPU, a sensor processor, or a CP. In an embodiment, the memory may include, for example, volatile memory or non-volatile memory. In an embodiment, the interface may include, for example, an HDMI, a USB interface, an SD card interface, and/or an audio interface. For example, the interface may electrically or physically connect the electronic device 801 to an external electronic device, and may include a USB connector, an SD card/multimedia card (MMC) connector, or an audio connector.

In an embodiment, the battery 830 may supply power to at least one component of the electronic device 801. The battery 830 may include, for example, a rechargeable secondary battery. For example, at least a portion of the battery 830 may be disposed on substantially the same plane as the PCB 840. The battery 830 may be disposed in the main body 800 and may be detachably connected to the main body 800.

In an embodiment, the first antenna 896 may be disposed between the display 861 and the support member 820. The first antenna 896 may include, for example, a near field communication (NFC) antenna, a wireless charging antenna, and/or a magnetic secure transmission (MST) antenna. In an embodiment, the first antenna 896 may perform short-range communication with an external device, wirelessly transmit and receive power used for charging, or transmit a magnetism-based signal including a short-range communication signal or payment data. In an embodiment, a portion of the side bezel structure 806 and/or a portion of the support member 820 may include a conductive portion, and the function of the first antenna 896 may be performed through the conductive portion.

In an embodiment, the second antenna 897 may be disposed between the PCB 840 and the rear plate 807. The second antenna 897 may include, for example, an NFC antenna, a wireless charging antenna, and/or an MST antenna. In an embodiment, the second antenna 897 may perform short-range communication with an external device, wirelessly transmit and receive power used for charging, or transmit a magnetism-based signal including a short-range communication signal or payment data. In an embodiment, a portion of the side frame 806 and/or the rear plate 807 may include a conductive portion, and the function of the second antenna 897 may be performed through the conductive portion.

In an embodiment, the sealing member 899 may be positioned between the side frame 806 and the rear plate 807. The sealing member 899 may be configured to block or reduce moisture or foreign matter entering the space between the side frame 806 and the rear plate 807 from the outside.

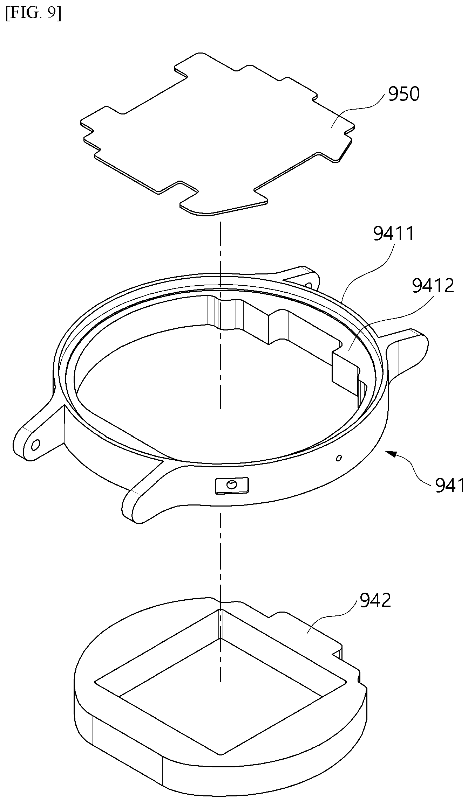

FIG. 9 is an example exploded perspective view of a housing structure of a wearable electronic device according to an embodiment.

Referring to FIG. 9, a housing structure, according to an embodiment, may include a side frame 941 (e.g., the side frame 806 of FIG. 8a) and a bracket 942.

In an embodiment, the side frame 806 may form a side surface of a main body (e.g., the main body 800 of FIG. 8a) of a wearable electronic device (e.g., the wearable electronic device 801 of FIG. 8a). In an embodiment, the side frame 806 may include a first metal member 9411 that forms at least a portion of a side surface and is exposed to the outside, and a second metal member 9412 connected to the first metal member 9411 along the inner perimeter of the first metal member. In an embodiment, the first metal member 9411 may be formed of a first metal material. In an embodiment, the second metal member 9412 may be formed of a second metal material.

In an embodiment, the bracket 942 may be connected to the interior of the side frame 941, for example, to the interior of the second metal member 9412. In an embodiment, the bracket 942 may be connected to the second metal member 9412 along the inner perimeter of the second metal member 9412. In an embodiment, a PCB 950 (e.g., the PCB 840 of FIG. 8c) on which a wireless communication circuit (e.g., the wireless communication module 192 of FIG. 1) is disposed may be disposed on the bracket 942. In an embodiment, a contact member (e.g., the contact member 653 of FIG. 6a) connected to the wireless communication circuit to form an electrical path may be disposed on the surface of the PCB 950.

In an embodiment, the first metal material forming the first metal member 9411 may have a higher surface hardness than the second metal material forming the second metal member 9412. For example, the first metal member 9411 may be directly exposed to the outside, then may be formed of a material having higher hardness and corrosion resistance than the second metal member 9412. In an embodiment, the second metal material may have higher thermal conductivity and conductivity compared to the first metal material.

In an embodiment, the first metal material may include at least one material among titanium, stainless steel, or aluminum. For example, the second metal material may include at least one material among stainless steel, a copper alloy, an aluminum-magnesium alloy, an aluminum-chromium alloy, an aluminum-titanium alloy, magnesium, or zinc. In an embodiment, the first metal material and the second metal material may be combined in various forms. For example, when the first metal material includes titanium, the second metal material may include stainless steel. For example, when the first metal material includes stainless steel, the second metal material may include at least one material among stainless steel, an aluminum alloy, a copper alloy, nickel, and cobalt of a different series from the first metal material. For example, when the first metal material includes aluminum, the second metal material may include at least one material among aluminum, magnesium, or zinc having a different grade from the first metal material.

In an embodiment, the second metal member 9412 may be integrally bonded to the first metal member 9411. For example, the first metal member 9411 and the second metal member 9412 may be joined together with diffusion bonding. In an embodiment, a bonding region (e.g., the bonding region 3413 of FIG. 4c) may be formed between the first metal member 9411 and the second metal member 9412 with a bonding interface (e.g., the bonding interface 3410 of FIG. 4c) in between. For example, the bonding region may be formed by mixing the first metal material forming the first metal member 9411 and the second metal material forming the second metal member 9412. In an embodiment, the bonding region may include a first diffusion layer (e.g., the first diffusion layer 4410a of FIG. 4c) formed on at least a portion of the first metal member 9411 from the bonding interface (e.g., the bonding interface 4410 of FIG. 4c) and a second diffusion layer (e.g., the second diffusion layer 4410b of FIG. 4c) formed on at least a portion of the second metal member 9412 from the bonding interface. In an embodiment, based on the bonding interface, the second diffusion layer may have a greater thickness than the first diffusion layer.

In an embodiment, an insulating member (e.g., the insulating member 343 of FIG. 3b) formed of an insulating material may be disposed on the side frame 941. The insulating member may cover the bonding region so that the bonding region of the first metal member 9411 and the second metal member 9412 is not exposed to the outside. In an embodiment, the insulating member may include one or more segment portions (e.g., the insulating portion 3431 of FIG. 3b) that divide the side frame 941 into a plurality of electrically separated conductive regions along a perimeter direction.

In an embodiment, the side frame 941 may be in contact with a contact member disposed on the surface of the PCB 950. In an embodiment, the side frame 941 may be connected to a wireless communication circuit through the contact member and may function as a radiator that transmits and receives a wireless signal of a wearable electronic device through a conductive region.

According to an embodiment, an electronic device 101, 201, or 301 may include a metal housing 240 or 340 including a side frame 241 or 341 forming a side surface 211c of the electronic device 201 or 301, and a bracket 342 connected to an interior of the side frame 241 or 341 and disposed in the electronic device 201 or 301. In an embodiment, the side frame 241 or 341 may include a first metal member 3411, 4411, 5411, or 6411 exposed on an exterior of the electronic device and including a first metal material, a second metal member 3412, 4412, 5412, or 6412 connected to the first metal member 3411, 4411, 5411, or 6411 along an inner perimeter of the first metal member 3411, 4411, 5411, or 6411 and including a second metal material, and a bonding region 4413 formed around a bonding interface 4410 between the first metal member 3411, 4411, 5411, or 6411 and the second metal member 3412, 4412, 5412, or 6412 and including a mixture of the first metal material and the second metal material. In an embodiment, the bonding region 4413 may include a first diffusion layer 4410a extending from the bonding interface 4410 to the first metal member 3411, 4411, 5411, or 6411, and a second diffusion layer 4410b extending from the bonding interface 4410 to the second metal member 3412, 4412, 5412, or 6412.

In an embodiment, a melting point of the first metal material may be higher than a melting point of the second metal material.

In an embodiment, a difference between the melting point of the first metal material and the melting point of the second metal material may be 300°C or less.

In an embodiment, based on the bonding interface 4410, a thickness of the first diffusion layer 4410a may be less than or equal to a thickness of the second diffusion layer 4410b.

In an embodiment, the first metal material may have a higher hardness than the second metal material.

In an embodiment, the first metal material may include at least one of titanium, stainless steel, or aluminum. In an embodiment, the second metal material may include at least one of stainless steel, a copper alloy, an aluminum-magnesium alloy, an aluminum-chromium alloy, an aluminum-titanium alloy, magnesium, or zinc.

In an embodiment, the metal housing 240 or 340 may further include an insulating member 343, 443, 543, or 643 including an insulating material and connected to the side frame 341, 441, 541, or 641 to cover the bonding region 4413. In an embodiment, the insulating member 343, 443, 543, or 643 may include one or more segment portions 3431 and 5431 configured to divide the side frame 341, 441, 541, or 641 into a plurality of electrically separated conductive regions along a perimeter direction.

In an embodiment, the side frame 341, 441, 541, or 641 may include a through hole 44122a or 54122a formed in the second metal member. In an embodiment, the insulating member 343 or 543 may be secured in the through hole 44122a or 54122a.

In an embodiment, the through hole 44122a or 54122a may be formed adjacent to the segment portion 3431 or 5431.

In an embodiment, the first metal member 3411, 4411, 5411, or 6411 may include a recess 54111 formed in at least a portion of an inner surface facing the second metal member 3412, 4412, 5412, or 6412. In an embodiment, the second metal member 3412, 4412, 5412, or 6412 may include an insertion portion 54121 engaging with and connected to the recess 54111.

In an embodiment, the electronic device 101, 201, or 301 may further include a PCB 350 or 650 disposed in the electronic device 101, 201, or 301, a wireless communication circuit 192, and one or more contact members 653 disposed on the PCB 350 or 650 and electrically connected to the wireless communication circuit. In an embodiment, the side frame 341, 441, 541, or 641 may include one or more contact portions 64115 and 64112, each of the one or more contact portions being in contact with a corresponding one of the one or more contact members 653.

In an embodiment, the first metal member 6411 may include a first contact portion 64115 extending toward an interior of the electronic device and being in contact with the contact member 653. In an embodiment, the first metal material and a third metal material forming the contact member 653 may have a potential difference of 0.2 or less.

In an embodiment, the second metal member 6412 may include a second contact portion 64112 that is in contact with the contact member 653.

In an embodiment, the side frame 541 may include a bonding portion 5415 extending toward an interior of the electronic device 201 or 301 and overlapping at least a portion of the bracket 542. In an embodiment, the bracket 542 may be bonded to the bonding portion 5415.

In an embodiment, the side frame 541 may include a guide groove 5416 formed through the bonding portion 5415. In an embodiment, the bracket 542 may include a guide member 5422 engaging with and inserted to the guide groove 5416.

According to an embodiment, an electronic device 201 or 301 may include a metal housing 740 including a first metal member 7411 exposed to an outside to form a side surface 211c of the electronic device 201 or 301 and including a first metal material, a second metal member 7412 bonded to the first metal member 7411 along an inner perimeter of the first metal member 7411 and including a second metal material, and an insulating member 743 including an insulating material, and a PCB 350 on which a wireless communication circuit 192 may be disposed. In an embodiment, a bonding region 3413 may be formed around a bonding interface 3410 between the first metal member 7411 and the second metal member 7412. In an embodiment, the bonding region 3413 may include a first diffusion layer 3410a and a second diffusion layer 3410b respectively formed in the first metal member 7411 and the second metal member 7412 with the bonding interface 3410 therebetween, the first diffusion layer 3410a and the second diffusion layer 3410b including a mixture of the first metal material and the second metal material. In an embodiment, the insulating member 743 may be connected to the first metal member 7411 and the second metal member 7412 to cover the bonding region 3413.

In an embodiment, the first metal material may have a higher melting point than the second metal material. In an embodiment, based on the bonding interface 3410, a first thickness T1 from the bonding interface 3410 to a boundary of the first diffusion layer 3410a may be less than or equal to a second thickness T2 from the bonding interface 3410 to a boundary of the second diffusion layer 3410b.

In an embodiment, the second metal member 7412 may include a bracket portion 7412-2 and a bonding portion 7412-1 bonded to an inner surface of the first metal member 7411 along a perimeter of the bracket portion 7412-2. In an embodiment, the insulating member 743 may include a segment portion 3431 configured to divide the bonding portion 7412-1 between the first metal member 7411 and the second metal member into a plurality of electrically separated conductive regions along a side surface of the electronic device 203 or 301.

In an embodiment, the PCB 350 or 550 may include one or more contact members 653 electrically connected to the wireless communication circuit 192. The one or more contact members 653 may be in contact with the first metal member 7411 or the second metal member 7412.

According to an embodiment, a wearable electronic device 801 may include a housing structure including a front surface 810A, a rear surface 810B, and a side surface 810C surrounding a space between the front surface and the rear surface and including a side frame 806 or 941 forming at least a portion of the side surface, and a strap 860 detachably connected to the housing structure and configured to be worn on a body of a user. In an embodiment, the side frame 806 or 941 may include a first metal member 9411 including a first metal material, forming at least a portion of the side surface, and exposed to an outside, a second metal member 9412 connected to the first metal member 9411 along an inner perimeter of the first metal member 9411 and including a second metal material, and a bonding region 3413 formed around a bonding interface 3410 between the first metal member 9411 and the second metal member 9412 and including a mixture of the first metal material and the second metal material. In an embodiment, the bonding region 3413 may include a first diffusion layer 3410a extending from the bonding interface 3410 to the first metal member 9411 and a second diffusion layer 3410b extending from the bonding interface 3410 to the second metal member 9412. In an embodiment, based on the bonding interface 3410, a thickness of the first diffusion layer 3410a may be less than or equal to a thickness of the second diffusion layer 3410b.

## Claims

1. An electronic device (101; 201; 301) comprising:
a metal housing (240; 340) comprising:
a side frame (241; 341) forming a side surface (211c) of the electronic device (201; 301); and
a bracket (342) connected to an interior of the side frame (241; 341) and disposed in the electronic device (201; 301),
wherein the side frame (241; 341) comprises:
a first metal member (3411; 4411; 5411; 6411) exposed on an exterior of the electronic device and comprising a first metal material;
a second metal member (3412; 4412; 5412; 6412) connected to the first metal member (3411; 4411; 5411; 6411) along an inner perimeter of the first metal member (3411; 4411; 5411; 6411) and comprising a second metal material; and
a bonding region (4413) formed around a bonding interface (4410) between the first metal member (3411; 4411; 5411; 6411) and the second metal member (3412; 4412; 5412; 6412) and comprising a mixture of the first metal material and the second metal material, and
wherein the bonding region (4413) comprises:
a first diffusion layer (4410a) extending from the bonding interface (4410) to the first metal member (3411; 4411; 5411; 6411); and
a second diffusion layer (4410b) extending from the bonding interface (4410) to the second metal member (3412; 4412; 5412; 6412).

2. The electronic device of claim 1, wherein a melting point of the first metal material is higher than a melting point of the second metal material.

3. The electronic device of any one of claims 1 and 2, wherein a difference between the melting point of the first metal material and the melting point of the second metal material is 300°C or less.

4. The electronic device of any one of claims 1 to 3, wherein, based on the bonding interface (4410), a thickness of the first diffusion layer (4410a) is less than or equal to a thickness of the second diffusion layer (4410b).

5. The electronic device of any one of claims 1 to 4, wherein the first metal material has a higher hardness than the second metal material.

6. The electronic device of any one of claims 1 to 5, wherein
the first metal material comprises at least one of titanium, stainless steel, or aluminum, and
the second metal material comprises at least one of stainless steel, a copper alloy, an aluminum-magnesium alloy, an aluminum-chromium alloy, an aluminum-titanium alloy, magnesium, or zinc.

7. The electronic device of any one of claims 1 to 6, wherein
the metal housing (240; 340) further comprises:
an insulating member (343; 443; 543; 643) comprising an insulating material and connected to the side frame (341; 441; 541; 641) to cover the bonding region (4413), and
the insulating member (343; 443; 543; 643) comprises one or more segment portions (3431; 5431) configured to divide the side frame (341; 441; 541; 641) into a plurality of electrically separated conductive regions along a perimeter direction.

8. The electronic device of claim 7, wherein
the side frame (341; 441; 541; 641) comprises a through hole (44122a; 54122a) formed in the second metal member, and
the insulating member (343; 543) is secured in the through hole (44122a; 54122a).

9. The electronic device of claim 8, wherein the through hole (44122a; 54122a) is formed adjacent to the one or more segment portion (3431; 5431).

10. The electronic device of any one of claims 1 to 9, wherein
the first metal member (3411; 4411; 5411; 6411) comprises a recess (54111) formed in at least a portion of an inner surface facing the second metal member (3412; 4412; 5412; 6412), and
the second metal member (3412; 4412; 5412; 6412) comprises an insertion portion (54121) engaging with and connected to the recess (54111).

11. The electronic device of any one of claims 1 to 10, further comprising:
a printed circuit board (PCB) (350; 650) disposed in the electronic device (101; 201; 301);
a wireless communication circuit (192); and
one or more contact members (653) disposed on the PCB (350; 650) and electrically connected to the wireless communication circuit,
wherein the side frame (341; 441; 541; 641) comprises one or more contact portions (64115; 64112), each of the one or more contact portions being in contact with a corresponding one of the one or more contact members (653).

12. The electronic device of any one of claims 1 to 11, wherein
the first metal member (6411) comprises a first contact portion (64115) extending toward an interior of the electronic device and being in contact with the one or more contact member (653), and
the first metal material and a third metal material forming the one or more contact member (653) have a potential difference of 0.2 or less.

13. The electronic device of any one of claims 1 to 12, wherein the second metal member (6412) comprises a second contact portion (64112) that is in contact with the contact member (653).

14. The electronic device of any one of claims 1 to 13, wherein
the side frame (541) comprises a bonding portion (5415) extending toward an interior of the electronic device (201; 301) and overlapping at least a portion of the bracket (542), and
the bracket (542) is bonded to the bonding portion (5415).

15. The electronic device of claim 14, wherein
the side frame (541) comprises a guide groove (5416) formed through the bonding portion (5415), and
the bracket (542) comprises a guide member (5422) engaging with and inserted to the guide groove (5416).
